Europäisches Patentamt

European Patent Office

Office européen des brevets

(19)

(11) Veröffentlichungsnummer: **0 149 042**

**B1**

(12) **EUROPÄISCHE PATENTSCHRIFT**

(45) Veröffentlichungstag der Patentschrift: 04.07.90

(21) Anmeldenummer: 84113494.3

(22) Anmeldetag: 08.11.84

(51) Int. Cl.⁵: **H 01 S 3/103,** H 01 S 3/19, H 01 S 3/23

(54) Halbleiter-Diodenlaser.

(30) Priorität: 13.01.84 DE 3401102
24.08.84 DE 3431228

(43) Veröffentlichungstag der Anmeldung:
24.07.85 Patentblatt 85/30

(45) Bekanntmachung des Hinweises auf die Patenterteilung:
04.07.90 Patentblatt 90/27

(84) Benannte Vertragsstaaten:
DE FR GB IT NL SE

(56) Entgegenhaltungen:
EP-A-0 047 601   US-A-3 702 975
FR-A-2 306 551   US-A-4 277 762
FR-A-2 475 813

APPLIED PHYSICS LETTERS, Band 43, Nr. 5, 1.
September 1983, Seiten 421-423, American
Institute of Physics, New York, US; E. KAPON et
al.: "Control of mutual phase locking of
monolithically integrated semiconductor lasers"

(73) Patentinhaber: Siemens Aktiengesellschaft
Wittelsbacherplatz 2
D-8000 München 2 (DE)

(72) Erfinder: Kappeler, Franz, Dr.
Narzissenstrasse 4
D-8039 Puchheim (DE)

**Beschreibung**

Die vorliegende Erfindung bezieht sich auf einen Halbleiter-Diodenlaser, wie im Oberbegriff des Patentanspruchs 1 angegeben.

Aus dem Stand der Technik sind einfrequente Halbleiter-Diodenlaser bekannt, deren Strahlung auch bei hochfrequenter Modulation des Betriebsstromes einfrequent bleibt. Der Aufbau solcher Halbleiter-Diodenlaser ist dadurch gekennzeichnet, daß im jeweiligen Halbleiterkörper mehrere in einer Schichtebene parallel nebeneinander oder linear hintereinander angeordnete laseraktive Streifen vorgesehen sind, die — bezogen auf den für den jeweiligen laseraktiven Streifen bzw. ihren optischen Resonator geltenden Schwellenwert der Anregung — mehr oder weniger, gegebenenfalls auch moduliert, angeregt werden.

Einzelheiten zu einem solchen Diodenlaser gehen aus der allgemeinen Übersicht in IEEE Spectrum, Dez. 1983, S. 38—45 hervor. Es sind dort insbesondere in der Figur der Seite 43 zahlreiche Möglichkeiten zur Realisierung eines solchen Diodenlasers gezeigt. Weitergehende Einzelheiten sind in den nachfolgend angeführten Druckschriften beschrieben:

US-Patentschrift 4 101 845 (Russer)

4. Intern. Conf. on Integrated Optics and Optical Fibre Comm., 27.—30.6.1983, Tokyo, S.24 u.25 u.S.30/31;

Appl. Phys. Letters, Bd.43 (1983), S.530—532 u.S.421—423;

Electronic Letters, Bd.19 (1983), No. 22, S.926—927;

Appl. Phys. Letters, Bd.41 (1982), S.112—114;

IEEE Journ. of Quantum Electronics, Bd.QE 18 (1982), S.1679—1687;

US-PS 4 277 762 und US—PS 4 347 612.

Die in diesen Druckschriften beschriebenen Diodenlaser haben zum Erreichen einfrequenter Laserstrahlung einen solchen Aufbau, daß die Laserstrahlung entlang ihrer Ausbreitungsrichtung mehr als einen Resonator durchläuft. Solchen Ausführungsformen liegt ein physikalisches Prinzip zugrunde, das schon zu Beginn der Sechziger Jahre insbesondere für Gaslaser bekanntgeworden war. Diese mehreren in Strahlungsrichtung hintereinander angeordneten optischen Resonatoren (Fabry-Perot-Resonatoren) lassen durch ihr Zusammenwirken erreichen, daß die erzeugte Laserstrahlung wenigstens praktisch gesehen nur eine einzige Frequenz hat. Normalerweise erzeugt nämlich ein Laser solche Laserstrahlung, die ein Multimoden-Spektrum und zahlreiche, wenn auch benachbart liegende, Frequenzen der Strahlung umfaßt. Die durch eine serielle Mehrfach-Resonatorstruktur mit Resonatoren mit voneinander abweichendem Resonanzfrequenzspektrum hindurchtretende Laserstrahlung erfährt ihre Frequenzselektion für eine übereinstimmende Eigen- bzw. Resonanzfrequenz der beteiligten Resonatoren.

Die erwähnte Druckschrift "4. Intern. Conf...." zeigt in Fig. 1 einen wie oben erwähnten Halbleiter-Diodenlaser, der im wesentlichen aus zwei, mit geringem Abstand benachbarten Halbleiterkörpern besteht, die sich auf einer Wärmesenke befinden. In den beiden Halbleiterkörpern sind für die Laserstrahlungserzeugung aktive Streifen ausgebildet, die stirnseitig einander gegenüberstehen und zusammen eine optische Achse haben. Strahlung aus dem einen aktiven Streifen gelangt in den anderen Streifen und umgekehrt. In Richtung dieser optischen Achse haben die Halbleiterkörper wenigstens im Regelfall voneinander verschiedene Längenabmessungen L1, L2, die auch die Längenabmessungen der durch die aktiven Streifen gebildeten optischen Resonatoren sind. Es sei darauf hingewiesen, daß auch die jeweilige Breitenabmessung der einzelnen Streifen die optisch wirksame Resonatorlänge mit bestimmt.

Die US-PS 4 101 845 zeigt in den Figuren 12 und 13 eine Ausführungsform mit parallel nebeneinander ausgerichteten laseraktiven Streifen, deren Abstand voneinander so gewählt ist, daß sich optische Kopplung gemäß Fig. 14 ergibt.

Durch Modulation des dem einen aktiven Streifen zuzuführenden elektrischen Stromes läßt sich eine Modulation emittierter modenreiner Laserstrahlung bewirken.

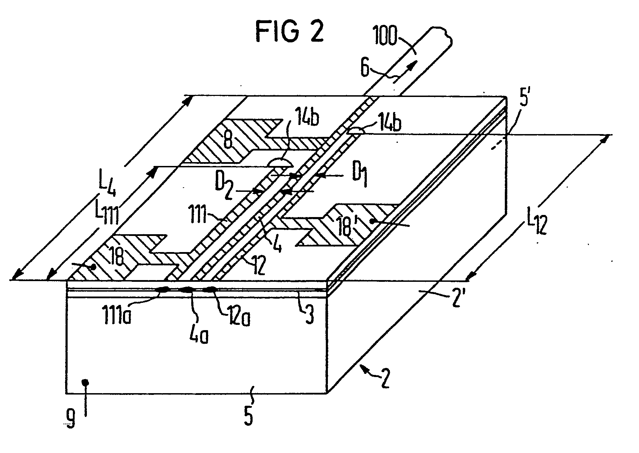

Durch gegebenenfalls steuerbare Bemessung des Gleichstromanteils des eingespeisten modulierten Stromes läßt sich die tatsächlich wirksame optische Länge des jeweiligen, den betreffenden aktiven Streifen enthaltenden optischen Resonators abstimmen, so daß insgesamt auch eine Verschiebung der Frequenzlage der erzeugten einfrequenten Laserstrahlung möglich ist (siehe Fig. 2 in "4. Intern. Conf....").

Wie ersichtlich, ist es entscheidend notwendig, daß die laseraktiven Streifen in dem einen bzw. in den mehreren Halbleiterkörpern außerordentlich exakt zueinander ausgerichtet sind.

Aufgabe der vorliegenden Erfindung ist, einen derartigen monomoden bzw. monofrequenten Halbleiter-Diodenlaser anzugeben, der in technologisch einfacher Weise herzustellen ist, vorzugsweise keines besonderen Justierungsaufwandes bedarf und der dennoch die für den Betrieb erforderliche mechanische und optische Stabilität, d.h. sowohl hohe Frequenzselektion als auch gute dynamische Frequenzstabilität, besitzt. Insbesondere soll der Aufwand gering gehalten sein, der im Zusammenhang mit Maskierungen bei der Herstellung der streifenförmigen leitenden Belegungen steht. Es sollen insbesondere Maßnahmen getroffen sein, die das Ankoppeln einer optischen Faserleitung an den Diodenlaser erleichtern. Es soll außerdem vermieden sein, daß die angewendeten Abstimm-Mittel nicht zu zusätzlicher Dämpfung führen.

Diese Aufgabe wird mit einem Halbleiter-Diodenlaser gelöst, der die Merkmale des Patentanspruchs 1 aufweist.

Ausgehend von der US-PS 4 101 845 beruht die vorliegende Erfindung auf der Erkenntnis, daß wesentliche Vorteile dadurch erreicht werden können, wenn man dem zur Laserstrahlungsaus-

2

sendung vorgesehenen, im Halbleiterkörper befindlichen, streifenförmigen aktiven Streifen mit seinem optischen Resonator (Fabry-Perot-Resonator) in diesem selben Halbleiterkörper parallel benachbart wenigstens einen weiteren streifenförmigen laseraktiven Streifen mit dessen optischem Resonator zuordnet, und zwar in der Weise, die noch näher auszuführen ist. Auch bei der Erfindung ist das Vorhandensein einer lateralen optischen Kopplung zwischen diesen beiden benachbarten optischen Resonatoren gegeben. Die Kopplung beruht auf der quer zur optischen Achse benachbarten Anordnung der beiden erwähnten Streifen bzw. optischen Resonatoren, und das Maß der Kopplung kann durch ihren Abstand voneinander und die Abmessung der Länge der Kopplungsabschnitte bestimmt werden, über die hinweg diese Kopplung wirksam ist.

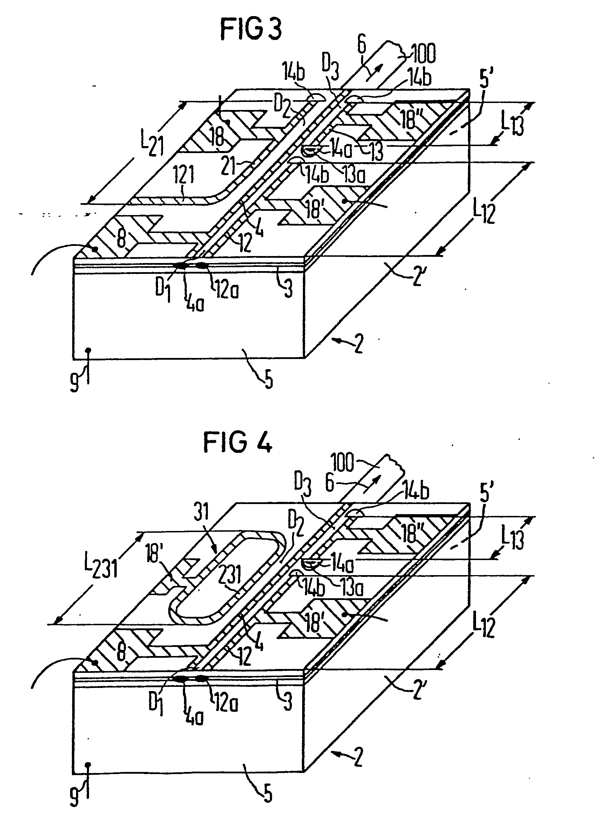

Es sei erwähnt, daß es ausreichend — und gegebenenfalls sogar vorteilhaft — ist, wenn nur ein Anteil der Resonatorlänge des zugeordneten optischen Resonators diesen Bedingungen der optischen Kopplung unterliegt (Fig. 3 bzw. 4).

Ein mit der Erfindung erkannter Vorteil benachbart angeordneter Laserstreifen besteht darin, daß in Ausbreitungsrichtung der Laserstrahlung der einzelnen aktiven Streifen in dem Diodenlaser keine Elemente vorhanden sind, die eine zusätzliche Dämpfung bewirken. Dies wirkt sich in besserer Frequenzstabilität eines Modes der Laserstrahlung aus. Im Zusammenhang mit der Erfindung wurde aber weiter erkannt, daß bei lateraler Verkopplung (quer zur optischen Achse) andererseits als Nachteil in erheblichem Maß Nebenschwingungen bzw. Nebenmoden auftreten und als weiterer Nachteil die einfrequente Laserschwingung des einen aktiven Streifens nicht unempfindlich ist gegen zurückreflektiertes Licht, das z.B. von Linsen oder Lichtwellenleitern in den anderen der benachbarten Streifen zurückreflektiert wird.

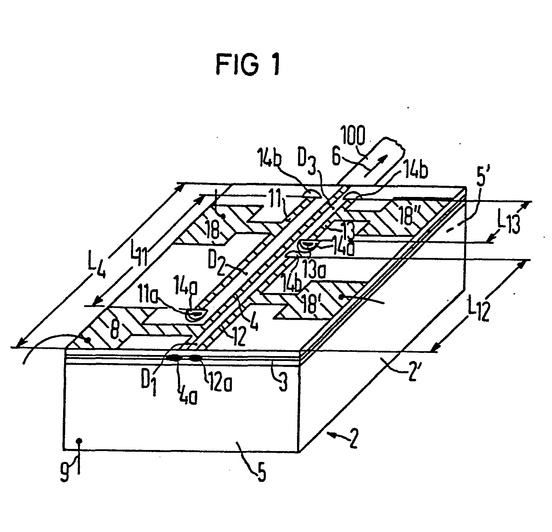

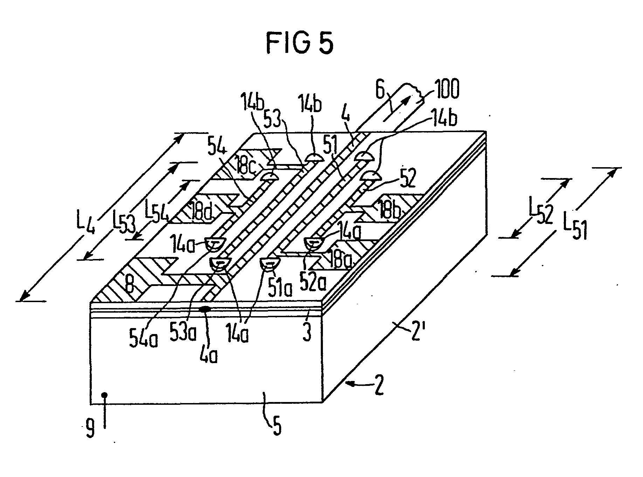

Die voranstehende Beschreibung bezog sich auf das Vorhandensein zweier (miteinander optisch gekoppelter) optischer Resonatoren, nämlich des die Laserstrahlung aussendenden aktiven Streifens und des zugeordneten aktiven Streifens. Erfindungsgemäß ist dem einen optischen Resonator des Laserstrahlung aussendenden aktiven Streifens je ein oder jeweils mehrere optische Resonatoren bzw. aktive Streifen auf beiden Seiten des erstgenannten optischen Resonators zuzuordnen. Dieser erstgenannte optische Resonator kann auf einer oder auf beiden Seiten auch von (jeweils) in Längsrichtung jeweils in Reihe hintereinander angeordneten zwei bzw. mehreren optischen Resonatoren flankiert sein (Fig. 1, 3, 4). Er kann auch von mehreren nebeneinander auf jeweils einer Seite angeordneten Resonatoren flankiert sein (Fig. 5). Zweckmäßigerweise sind die mehreren dem optischen Resonator des die Strahlung aussendenden aktiven Streifens zuzuordnenden optischen Resonatoren (der weiteren zugeordneten aktiven Streifen) in ihrer optischen Länge so einzustellen, daß die Abstände der Eigen-Resonanzfrequenzen in ihrem jeweiligen Spektrum sich voneinander unterscheiden und sich auch von den Abständen der Eigen-Resonanzfrequenzen im Spektrum des optischen Resonators des die Laserstrahlung aussendenden aktiven Streifens unterscheiden.

Bei der Erfindung ist als wesentliches weiteres Merkmal vorgesehen, daß die weiteren laseraktiven Streifen, die zu den weiteren streifenförmigen Belegungen gehören, an ihrem jeweils einen Ende nicht bis an die ihnen benachbarte, der Aussendung der Laserstrahlung vorbehaltete Stirnfläche (in der Figur die rückwärtige Stirnfläche 5') heranreichen. Damit steht außerdem die gesamte Stirnfläche 5' z.B. der Ankopplung einer Faserleitung zur Verfügung.

Ein wesentlicher Vorteil dieser Anordnung bei der Erfindung besteht darin, daß durch die jeweils kürzere Resonatorlänge der weiteren laseraktiven Streifen eine sehr hohe Unterdrükkung unerwünschter Nebenfrequenzen der Laserstrahlung erreicht wird. Ein weiterer wesentlicher Vorteil ist, daß durch die Verkopplung mehrerer Laserresonatoren quer zur optischen Achse die bei herkömmlichen Laserstrukturen unter dem Einfluß eines hochfrequenten Modulationsstromes auftretende Schwankung der Laserfrequenz erheblich reduziert wird. Dies wird dadurch erreicht, daß nur der zur Emission von Laserstrahlung vorgesehene Laserstreifen 4, 4a mit einem hochfrequenten Stromanteil moduliert wird, während die zugeordneten weiteren Laserresonatoren nur statisch betrieben werden und somit eine frequenzstabilisierende Wirkung auf den modulierten Laserstreifen ausüben.

Weitere Erläuterungen der Erfindung gehen aus der nachfolgenden Beschreibung zu Ausführungsbeispielen der Erfindung hervor.

Fig. 1 eine Darstellung, die mehrere Varianten einer Ausführungsform der Erfindung umfaßt,

Fig. 2, 3 und 5 weitere Varianten und

Fig. 4 eine weitere Variante mit einem zugeordneten optischen Resonator mit besonders hoher Güte.

In Fig. 1 ist mit 2 ein Halbleiterkörper, z.B. aus Galliumarsenid, bezeichnet. Wie dies von Hetero-Streifen-Diodenlasern bekannt ist, befindet sich auf der einen Hauptfläche eines Substrats 2' eine Anzahl aufeinanderliegender, insbesondere epitaktisch abgeschiedener Schichten 3, die zusammen mit dem Substrat 2' den Halbleiterkörper 2 des Diodenlasers bilden. Innerhalb einer dieser Schichten 3 liegt unterhalb einer streifenförmigen leitenden Belegung 4 der Oberfläche in an sich bekannter Weise die Zone eines laseraktiven Streifens 4a, in dem bei Stromfluß, und zwar wenn dort die Stromdichte einen bestimmten Schwellenwert überschreitet, durch Selbsterregung Laserstrahlung erzeugt wird. Dadurch, daß an dem Halbleiterkörper 2 einander gegenüberliegende Stirnflächen 5 und nicht sichtbar 5' vorhanden sind, die bei Angrenzen an Luft für die erzeugte Laserstrahlung bekanntermaßen spiegelnde Wirkung haben, liegt — wie ebenfalls hinlänglich bekannt — im Halbleiterkörper ein (jeweiliger) optischer Resonator vor. Aufgrund der jedoch begrenzt spiegelnden Wirkung der Flächen 5' tritt durch die Fläche 5' hindurch ein mit 6 angedeuteter Laserstrahl aus dem optischen Resonator des einen aktiven Streifens 4a (z.B. in die Faserleitung 100 hinein) aus. Innerhalb des ihm zugehörigen optischen Resonators tritt — wie bekannt — vielfacher Hin- und Herlauf der erzeugten Laserstrahlung zwischen den erwähnten spiegelnden Flächen 5, 5' auf.

Auf der oberen Fläche der obersten der Schichten 3, d.h. auf der Oberfläche des aus den Anteilen 2' und 3 bestehenden Halbleiterkörpers 2, ist die Elektrodenbelegung vorhanden, die zum besseren Erkennen mit einer Schraffur hervorgehoben ist. Sie besteht aus der streifenförmigen Belegung 4 und einem sich über einen Verbindungsstreifen mit elektrischer Verbindung daran anschließenden Anschluß 8. Die örtliche Lage der streifenförmigen leitenden Belegung 4 bestimmt die örtliche Lage des aktiven Streifens 4a, in der die gewünschte Laserstrahlung erzeugt und als Laserstrahlung 6 austritt. In welcher der Schichten 3 die Laserstrahlung erzeugt wird ergibt sich aus der Schichtwahl. Gegenelektrode zur streifenförmigen Elektrodenbelegung 4 ist der Substratkörper 2 mit seinem elektrischen Anschluß 9.

Die voranstehend beschriebenen Einzelheiten zum Ausführungsbeispiel sind bekannter Stand der Technik und bedürfen für den einschlägigen Fachmann keiner noch weiter ins Detail gehenden Erläuterung.

Wie aus der Darstellung der Fig. 1 ersichtlich, sind auf der bereits erwähnten Oberfläche der Schichten 3 wenigstens zwei weitere streifenförmige leitende Belegungen vorgesehen. Diese weiteren streifenförmigen leitenden Belegungen sind mit 11, 12 und 13 bezeichnet. Jede dieser streifenförmigen Belegungen hat vorzugsweise einen jeweiligen eigenen Anschluß 18, 18', 18'', der elektrisch leitend mit der zugeordneten streifenförmigen Belegung 11 bzw. 12 bzw. 13 verbunden ist.

Durch jeweiligen Stromfluß zwischen den Anschlüssen 18 und der Gegenelektrode 9 kann ebenso, wie dies für den aktiven Streifen 4a schon näher beschrieben worden ist, unterhalb dieser leitenden Belegungen 11 bzw. 12 bzw. 13 Laserstrahlung angeregt werden, wenn man den fließenden Strom den jeweiligen Schwellenwert für selbsterregte Strahlungserzeugung überschreiten läßt. Dabei ist jeweils ein optischer Resonator wirksam, der — wie bekannt — zwischen einander gegenüberstehenden spiegelnden Flächen ebenso vorliegt, wie im Zusammenhang mit dem zur streifenförmigen leitenden Belegung 4 gehörenden optischen Resonator des aktiven Streifens 4a beschrieben ist. Keine der streifenförmigen leitenden Belegungen 11 bis 13 reicht an ihrem einen Ende bis zur Stirnfläche 5' des Substratkörpers, wo die Strahlung 6 ausgesandt wird. In Richtung zur Stirnfläche 5' enden die Belegungen 11, 12 und 13 und enden somit auch die zugehörigen laseraktiven Streifen 11a, 12a, 13a mit ihren zugehörigen Resonatoren an vorgegebenen Stellen (Gruben 14b). Es können hierzu z.B. von oben her in das Schichtsystem 3 und gegebenenfalls weiter in den Substratkörper 2' hinein sich erstreckende, z.B. durch örtlich begrenzte Ionenätzung, erzeugte Gruben 14b vorgesehen sein. In jeder der Gruben gibt es eine senkrechte Stirnfläche innerhalb des Schichtsystems 3. Diese "inneren" Stirnflächen sind so eben und glatt ausgeführt, daß sie wenigstens im wesentlichen ebensolche spiegelnde Wirkung haben, wie dies für die Stirnflächen 5, 5' der Fall ist. Entsprechendes gilt für die Gruben 14a der der Stirnfläche 5 zugewandten Richtung.

Bei der Erfindung ist vorgesehen, den Stromfluß bzw. dessen Stromdichte für die weiteren aktiven Streifen 11a, 12a, 13a unterhalb der Belegungen 11, 12 und 13 — für jeden Streifen für sich genommen — kleiner als den für Laserstrahlungserzeugung notwendigen Schwellenwert zu halten. Es liegt dort somit jeweils ein aktiver Streifen mit optischem Resonator vor, in dem aufgrund des unterhalb der Laserschwelle liegenden Stromwertes für sich genommen noch keine Laserstrahlungserzeugung erfolgt. Durch die optische Verkopplung mit dem die Laserstrahlung aussendenden Streifen 4a wird jedoch erreicht, daß die weiteren aktiven Streifen 11a, 12a... zusammen mit dem Streifen 4a ein System von synchronisierten Laseroszillatoren bilden. Wie insbesondere aus der Fig. 1 ersichtlich, erstrecken sich die Belegungen 11, 12, 13 einerseits und die Belegung 4 andererseits in wenigstens im wesentlichen paralleler Ausrichtung seitlich benachbart nebeneinander. Um die laterale optische Kopplung zwischen dem Laserstrahlung aussendenden aktiven Streifen 4a und den mehreren benachbart angeordneten aktiven Streifen 11a, 12a, 13a mit optischem Resonator zu erreichen, sind die Abstände D1, D2 und D3 maximal etwa 100, vorzugsweise nicht mehr als 50, und insbesondere bis etwa 3D Wellenlängen der Laserstrahlung groß bemessen. Bei dieser Wellenlängenangabe handelt es sich um die im Halbleitermaterial jeweils auftretende Wellenlänge.

Wie auch aus der Fig. 1 ersichtlich, erstrecken sich die jeweiligen aktiven Streifen 11a, 12a, 13a, d.h. die den Strom zuführenden leitenden Belegungen 11, 12, 13 vorteilhafterweise nicht entlang der gesamten Länge des aktiven Streifens 4a bzw. der streifenförmigen Belegung 4. Um zu gewährleisten, daß auch in ungünstigen bzw. kritischen Betriebsfällen die insbesondere modulierte Laserstrahlung 6 einfrequent ist bzw. der der Belegung 4 zugeordnete aktive Streifen eine einfrequente Strahlung 6 liefert, sind beiderseits der streifenförmigen leitenden Belegung 4 die streifenförmigen leitenden Belegungen 11 und 12 oder 13 vorgesehen. Eine Variante ist, die in Fig. 1 gezeigte Zuordnung vorzusehen, die außer der weiteren Belegung 11 die beiden hintereinanderliegenden streifenförmigen leitenden Belegungen 12 und 13 hat.

Wie bereits eingangs erwähnt, enthält die Darstellung der Fig. 1 bereits drei Varianten zu speziellen Ausführungsformen der Erfindung. Eine Abänderung der einen Variante ist in Fig. 2 gezeigt, in der mit Fig. 1 übereinstimmende Einzelheiten dieselben Bezugszeichen haben. Die Belegung 111 entspricht der Belegung 11. Sie ist lediglich anders angeordnet mit einem Ende des laseraktiven Streifens 111a in der Stirnfläche 5. Es entfällt hier die Grube 14a des Streifens 11. Eine noch weitere Variante zeigt die Fig. 3. Die in Fig. 3 enthaltenen und zur Fig. 1 bereits beschriebenen Bezugszeichen haben in Fig. 3 die jeweils selbe Bedeutung wie in Fig. 1. Die streifenförmige leitende Belegung 21 in Fig. 3 weist eine wie aus der Figur ersichtliche Ausgestaltung auf, nämlich ihr eines Ende verläuft nach einer 90° Krümmung als Anteil 121 zu einer seitlichen Kantenfläche der Schichten 3. Diese Form bzw. Wegführung der Belegung 21 (eingeschlossen der Anteil 121) bildet einen darunter auf dem gleichen Weg verlaufenden aktiven Streifen mit einem optischen Resonator, dessen eine spiegelnde Endfläche mit der seitlichen Fläche des Halbleiterkörpers 2 zusammenfällt. Die andere spiegelnde Endfläche des optischen Resonators des der Belegung 21 zugehörigen aktiven Streifens endet erfindungsgemäß schon im Halbleiterkörper in der Grube 14b. Eine Ausführungsform nach Fig. 3 kann z.B. in der Hinsicht vorteilhaft sein, daß die Länge des optischen Resonators des der Belegung 21 zugeordneten aktiven Streifens eine relativ größere Resonatorlänge L21 und damit größere Resonatorgüte haben kann. Dies kann sich positiv für die Stabilität der Erzeugung einfrequenter Laserstrahlung 6 auswirken. Die wellenoptische Kopplung mit dem Streifen 4a ist aber auf die Länge L21 beschränkt.

Eine weitere Variante einer Ausführungsform nach der Erfindung und insbesondere eine Weiterbildung der Ausführungsform nach Fig. 3 zeigt Fig. 4, bei der die eine streifenförmige Belegung ein wie dargestellter, vorzugsweise länglicher, Ring 31 ist, dessen Anteil 231 die Bedingung erfüllt, sich benachbart im wesentlichen parallel zur streifenförmigen Belegung 4 des die Strahlung 6 erzeugenden aktiven Streifens zu erstrekken. Für diesen Anteil 231 liegt die (im wesentlichen auf dem Abstand Dl beruhende) laterale Kopplung vor. Mit dem Ring 31 ist ein Ringlaser realisiert, der besonders hohe Resonatorgüte besitzt.

Fig. 5 zeigt eine Ausführungsform, bei der auf beiden Seiten des für die auszusendende Laserstrahlung 6 vorgesehenen laseraktiven Streifens 4a, d.h. auf beiden Seiten der streifenförmigen Belegung 4, jeweils mehrere weitere laseraktive Streifen mit den zugehörigen streifenförmigen Belegungen angeordnet sind. Es sind dies die streifenförmigen Belegungen 51 und 52 auf der einen Seite und die streifenförmigen Belegungen 53 und 54 auf der anderen Seite der streifenförmigen Belegung 4. Die den streifenförmigen Belegungen 51—54 entsprechenden Resonatoren dieser weiteren laseraktiven Streifen 51a, 52a, 53a und 54a haben an ihren Enden spiegelnde Flächen in den Gruben 14a und 14b. Keine dieser weiteren laseraktiven Streifen reichen bis zur Stirnfläche 5' des Halbleiterkörpers 2, an die sich die optische Faser IDO anschließt. Mit 18a—18d sind die entsprechenden Anschlüsse bezeichnet. Wie auch aus der Fig. 5 ersichtlich, sind die weiteren laseraktiven Streifen 51—54a vorteilhafterweise zusammengenommen wenigstens im wesentlichen symmetrisch zu dem die Laserstrahlung 6 aussendenden laseraktiven Streifen 4a angeordnet. Die Streifen 51, 52 bzw. 53, 54 einer Seite können u.a. aus dem Grund voneinander unterschiedlich lang gewählt sein, um die Anschlüsse 18a und 18c in technologisch einfacher Weise mit der jeweiligen streifenförmigen Belegung 51 bzw. 53 zu verbinden.

Durch Wahl der Stromstärken bzw. Stromdichten im jeweiligen aktiven Bereich können die diesen Bereichen jeweils zugehörigen Resonatoren (zueinander) so abgestimmt werden, daß sich im Ergebnis die einfrequente Laserstrahlung 6 ergibt. Diese Abstimmung hat eine gewisse Abstimmbreite.

Innerhalb dieser Abstimmbreite kann durch weitere Feinabstimmung der Stromstärken außerdem noch der Frequenzwert dieser einfrequenten Strahlung steuerbar verändert werden.

Die in den Figuren dargestellten Ausführungsformen haben den Vorteil, daß an der rückwärtigen Stirnfläche 5' des Halbleiterkörpers 2 nur Laserstrahlung des einen laseraktiven Streifens unterhalb der streifenförmigen Belegung 4 auftritt. Durch vergleichsweise zu den Abständen $D_1$ und $D_2$ größere Querschnittsabmessungen der sich anschließenden Faserleitung 100 können bei der Ausführungsform dieser Erfindung keine mechanischen und/oder optischen Probleme auftreten.

Wie ersichtlich, gibt es bei der dargestellten bevorzugten Ausführungsform keine Überschneidungen der Anschlüsse 8, 18, 18' mit irgendwelchen der Zonen unterhalb der streifenförmigen Belegungen 4, 12, 111. Dadurch können die elektrischen Kontakte besonders einfach, d.h. ohne besondere Maßnahmen zur gegenseitigen Isolation, ausgeführt werden.

## Patentansprüche

1. Halbleiter-Diodenlaser für einfrequente Laserstrahlung, deren Frequenz abstimmbar ist, mit einer Mehrzahl laseraktiver Streifen mit jeweiligem optischen Resonator, wobei zwischen benachbarten Streifen laterale wellenoptische Kopplung vorliegt, wobei diese Streifen über ihre ganze Koppellänge zueinander parallel ausgerichtet im Abstand voneinander in einem einzigen Halbleiterkörper angeordnet sind, wobei die Größe der jeweiligen Kopplung durch den jeweils gewählten Abstand und die jeweils gewählte wirksame Koppellänge des parallelen Verlaufs benachbarter Streifen eingestellt ist, und wobei einer der laseraktiven Streifen als auszusendende Laserstrahlung erzeugender Streifen vorgesehen ist und dieser Streifen für sich allein einen elektrischen Anschluß hat, gekennzeichnet dadurch, daß auf beiden Seiten des zur Aussendung von Laserstrahlung (6) vorgesehenen laseraktiven Streifens (4) weitere laseraktive Streifen (11, 12, 13, 21, 31, 51—54) vorgesehen sind, daß diese weiteren laseraktiven Streifen kürzer als der die Laserstrahlung aussendende Streifen (4) sind und daß diese weiteren laseraktiven Streifen im Halbleiterkörper (2) so angeordnet sind, daß sie mit ihrem jeweils einen Ende (14b) ihrer an jeweils beiden Enden mit Spiegeln versehenen Resonatoren in einem Abstand vor derjenigen Stirnfläche (5') der beiden Stirnflächen (5, 5') des Halbleiterkörpers (2) enden, durch die (5') hindurch die auszusendende Laserstrahlung (6) auszukoppeln ist.

2. Diodenlaser nach Anspruch 1, gekennzeichnet dadurch, daß die jweils anderen Enden (12a, 111a) wenigstens eines weiteren laseraktiven Streifens (12, 111) an derjenigen Stirnfläche (5) des Halbleiterkörpers (2) enden, die für Aussendung der Laserstrahlung (6) nicht verwendet ist.

3. Diodenlaser nach Anspruch 1, gekennzeichnet dadurch, daß wenigstens einer der weiteren laseraktiven Streifen mit keinem seiner jeweiligen Enden (14a, 14b) bis an die Stirnflächen (5, 5') des Halbleiterkörpers heranreicht.

4. Diodenlaser nach Anspruch 1, 2 oder 3, gekennzeichnet dadurch, daßdie einzelnen Längen (L) dieser weiteren laseraktiven Streifen jeweils bezogen auf die Längserstreckung des zur Aussendung von Laserstrahlung (6) vorgesehenen laseraktiven Streifens (4) derart angeordnet sind, daß die Längen (L) der weiteren laseraktiven Streifen (12, 13; 11; 31) sich symmetrisch zur Länge ($L_4$) des zur Aussendung von Laserstrahlung (8) vorgesehenen laseraktiven Streifens erstrecken (Fig. 1, 4).

5. Diodenlaser nach Anspruch 1, 2, 3 oder 4, gekennzeichnet dadurch, daß die Abstände (D) des jeweiligen weiteren laseraktiven Streifens von dem zur Aussendung von Laserstrahlung (6) vorgesehenen laseraktiven Streifen (4) gleich groß sind ($D_1 = D_2 = D_3$).

6. Diodenlaser nach einem der Ansprüche 1 bis 5, gekennzeichnet dadurch, daß alle weiteren laseraktiven Streifen wenigstens im wesentlichen symmetrisch zur Längsachse des zur Aussendung von Laserstrahlung (6) vorgesehenen laseraktiven Streifens (4) angeordnet sind (Fig. 1, 4, 5).

7. Diodenlaser nach einem der Ansprüche 1 bis 6, gekennzeichnet dadurch, daß auf beiden Seiten des zur Aussendung von Laserstrahlung (6) vorgesehenen laseraktiven Streifens (4) jeweils nebeneinander mehr als ein weiterer laseraktiver Streifen vorgesehen ist (Fig. 5).

8. Diodenlaser nach einem der Ansprüche 1 bis 7, gekennzeichnet dadurch, daß auf wenigstens einer Seite des Laserstrahlung (6) erzeugenden aktiven Streifens (4) parallel zu diesem Streifen hintereinanderliegende weitere aktive Streifen (12; 13) angeordnet sind (fig. 1, 3, 4).

9. Diodenlaser nach einem der Ansprüche 1 bis 8, gekennzeichnet dadurch, daß ein weiterer aktiver Streifen (31) als Ringstreifen ausgebildet ist (Fig. 4).

10. Diodenlaser nach einem der Ansprüche 1 bis 9, gekennzeichnet dadurch, daß wenigstens einer der weiteren aktiven Streifen (21) einen von dem die Laserstrahlung (6) erzeugenden aktiven Streifen (4) richtungsmäßig abweichenden Anteil (121) hat.

11. Diodenlaser nach einem der Ansprüche 1 bis 10, gekennzeichnet dadurch, daß wenigstens eine Mehrzahl der den einzelnen aktiven Streifen zugehörenden leitenden Belegungen (4, 11, 12, 13, 21, 31, 51—54) einen eigenen elektrischen Anschluß (8, 18, 18', 18''...) besitzt.

12. Diodenlaser nach einem der Ansprüche 1 bis 11, gekennzeichnet dadurch, daß wenigstens eine der Spiegelflächen des optischen Resonators der weiteren aktiven Streifen durch eine mittels Ionenätzung im Halbleiterkörper (2) erzeugte Grube (14a, 14b) gebildet ist.

**Revendications**

1. Diode laser à semiconducteurs pour un rayonnement à laser possédant une fréquence, qui est réglable, et comportant une multiplicité de bandes fournissant l'effet laser et comportant chacune un résonateur optique, et dans lequel un couplage latéral pour les ondes optiques existe entre des bandes voisines, ces bandes étant disposées à distance les unes des autres dans un corps semiconducteur unique, en étant parallèles entre elles sur toute leur longueur de couplage, la taille du couplage respectif étant réglée au moyen de la distance respectivement choisie et de la longueur de couplage active respectivement choisie de la disposition en parallèle de bandes voisines, et l'une des bandes produisant l'effet laser étant prévue en tant que bande produisant un rayonnement laser devant être émis et cette bande comportant, pour elle seule, une borne électrique, caractérisé par le fait que d'autres bandes (11, 12, 13, 21, 31, 51—54) actives pour l'effet laser sont prévues des deux côtés de la bande (4) active pour l'effet laser, qui est prévue pour l'émission du rayonnement laser (6), que ces autres bandes actives pour l'effet laser sont plus courtes que la bande (4) émettant le rayonnement laser, et que ces autres bandes actives pour l'effet laser sont disposées dans le corps semiconducteur (2) de telle sorte qu'elles se terminent, par une première extrémité respective (14b) de leurs résonateurs comportant des miroirs au niveau de leurs deux extrémités respectives, à une certaine distance en avant de celle (5') des deux surfaces frontales (5,5') du corps semiconducteur (2), à travers laquelle le rayonnement laser (6) devant être émis doit être extrait par découplage.

2. Diode laser suivant la revendication 1, caractérisée par le fait que les autres extrémités respectives (12a, 111a) d'au moins une autre bande (12, 111) active pour l'effet laser se terminent au niveau de la surface frontale (5) du corps semiconducteur (2), qui n'est pas utilisée pour l'émission du rayonnement laser (6).

3. Diode laser suivant la revendication 1, caractérisée par le fait qu'aucune des extrémités respectives (14a, 14b) d'au moins l'une des autres bandes actives pour l'effet laser ne s'étend jusqu'aux faces frontales (5, 5') du corps semiconducteur.

4. Diode laser suivant la revendication 1, 2 ou 3, caractérisée par le fait que les différentes longueurs (L) de ces autres bandes actives pour l'effet laser, rapportées respectivement à l'étendue en longueur de la bande (4) active pour l'effet laser, prévue pour l'émission du rayonnement laser (6), sont disposées de telle sorte que les longueurs (L) des autres bandes (12, 13; 11; 31) actives pour l'effet laser s'étendent symétriquement par rapport à la longueur ($L_4$) de la bande active pour l'effet laser, prévue pour l'émission du rayonnement laser (8) (figures 1, 4).

5. Diode laser suivant la revendication 1, 2, 3 ou 4, caractérisée par le fait que les distances (D) des autres bandes respectives, actives pour l'effet laser, par rapport à la bande (4) active pour l'effet laser et prévue pour l'émission du rayonnement laser (6), sont égales ($D_1=D_2=D_3$).

6. Diode laser suivant l'une des revendications 1 à 5, caractérisée par le fait que toutes les autres bandes actives pour l'effet laser sont disposées au moins d'une manière sensiblement symétrique par rapport à l'axe longitudinal de la bande (4), active pour l'effet laser, prévue pour l'émission du rayonnement laser (6) (figures 1, 4, 5).

7. Diode laser suivant l'une des revendications 1 à 6, caractérisée par le fait que des deux côtés de la bande (4) active pour l'effet laser, prévue pour l'émission du rayonnement laser (6), il est prévu respectivement côte-àcôte plus d'une autre bande active pour l'effet laser (figure 5).

8. Diode laser suivant l'une des revendications 1 à 7, caractérisée par le fait que sur au moins un côté de la bande active (4) produisant le rayonnement laser (6) sont disposées les unes derrière les autres parallèlement à cette bande, d'autres bandes actives (12; 13) (figures 1, 3, 4).

9. Diode laser suivant l'une des revendications 1 à 8, caractérisée par le fait qu'une autre bande active (31) est réalisée sous la forme d'une bande annulaire (figure 4).

10. Diode laser suivant l'une des revendications 1 à 9, caractérisée par le fait qu'au moins l'une des autres bandes actives (21) possède une partie (121) dont la direction s'écarte de celle de la bande active (4) produisant le rayonnement laser (6).

11. Diode laser suivant l'une des revendications 1 à 10, caractérisée par le fait qu'au moins une multiplicité des revêtements conducteurs (4, 11, 12, 13, 21, 31, 51—54), associés aux différentes bandes actives, possèdent une borne électrique propre (8, 18, 18', 18'',...).

12. Diode laser suivant l'une des revendications 1 à 11, caractérisée par le fait qu'au moins l'une des surfaces réfléchissantes du résonateur optique des autres bandes actives est formée par un sillon (14a, 14b) ménagé par corrosion ionique dans le corps semiconducteur (2).

**Claims**

1. Semiconductor diode laser for tunable single frequency laser radiation, comprising a plurality of laser-active strips with respective optical resonator, a lateral wave-optical coupling being present between neighbouring strips, said strips being disposed aligned parallel to one another over their entire coupling length at an interval from one another in a single semiconductor body, the size of the respective coupling being set by the given selected interval and the given selected effective coupling length of the parallel course of neighbouring strips, and one of the laser-active strips being designated as a strip generating laser radiation to be emitted and said strip having an electrical connection for itself alone, characterized in that further laser-active strips (11, 12, 13, 21, 31, 51—54) are provided on both sides of the laser-active strip (4) provided for emitting laser radiation (6), in that said further laser-active strips are shorter than the strip (4) emitting the laser radiation, and in that said further laser-active strips are arranged in the semiconductor body (2) such that with the one given end (14b) of their resonators which are provided at both given ends with mirrors, they terminate at a distance in front of that end face (5') of the two end faces (5, 5') of the semiconductor body (2) through which (5') the laser radiation (6) to be emitted is to be coupled out.

2. Diode laser according to Claim 1, characterized in that the given other ends (12a, 111a) of at least one further laser-active strip (12, 111) terminate at that end face (5) of the semiconductor body (2) not employed for the emission of the laser radiation (6).

3. Diode laser according to Claim 1, characterized in that at least one of the further laser-active strips does not extend up to the end faces (5, 5') of the semiconductor body with either of its respective ends (14a, 14b).

4. Diode laser according to Claim 1, 2 or 3, characterized in that the individual lengths (L) of said further laser-active strips are respectively disposed relative to the longitudinal extent of the laser-active strip (4) provided for emitting laser radiation (6) such that the lengths (L) of the further laser-active strips (12, 13; 11; 31) extend symmetrically relative to the length ($L_4$) of the laser-active strip provided for emitting laser radiation (8) (Fig. 1, 4).

5. Diode laser according to Claim 1, 2, 3 or 4, characterized in that the intervals (D) of the respective further laser-active strip from the laser-active strip (4) provided for emitting laser radiation (6) are of equal size ($D_1 = D_2 = D_3$).

6. Diode laser according to one of Claims 1 to 5, characterized in that all further laser-active strips are disposed at least essentially symmetrically relative to the longitudinal axis of the laser-active strip (4) provided for emitting laser radiation (6) (Fig. 1, 4, 5).

7. Diode laser according to one of Claims 1 to 6, characterized in that more than one further laser-active strips are provided next to one another in each case on both sides of the laser-active strip (4) provided for emitting laser radiation (Fig. 5).

8. Diode laser according to one of Claims 1 to 7, characterized in that further active strips (12; 13) are disposed lying behind one another on at least one side of the active strip (4) generating the laser radiation (6) parallel to the said strip (Fig. 1, 3, 4).

9. Diode laser according to one of Claims 1 to 8, characterized in that a further active strip (31) is designed as a ring strip (Fig. 4).

10. Diode laser according to one of Claims 1 to 9, characterized in that at least one of the further active strips (21) has a portion (121) which deviates in a direction away from the active strip (4) generating the laser radiation (6).

11. Diode laser according to one of Claims 1 to 10, characterized in that at least a majority of the conducting coatings (4, 11, 12, 13, 21, 31, 51—54) associated with the individual active strips have their own electrical terminal (8, 18, 18', 18''...).

12. Diode laser according to one of Claims 1 to 11, characterized in that at least one of the mirror faces of the optical resonator of the further active strips is formed by a trench (14a, 14b) produced in the semiconductor body (2) by means of ion etching.

## FIG 1

FIG 2

# FIG 3

# FIG 4

# FIG 5